# EUROPEAN PATENT APPLICATION

(11) **EP 4 746 587 A1**
(43) Date of publication of application: **20.05.2026**
(21) Application number: 24212803.1
(22) Date of filing: 13.11.2024
(51) Int. Cl.: H05K 1/02, H05K 3/02, B23K 26/362

(54) **APPARATUS FOR TREATING A SURFACE OF A PRINTED CIRCUIT BOARD, A PRINTED CIRCUIT BOARD WITH A MULTI-PROFILED SHAPED PORTION, AND A METHOD**

(71) Applicant: AT & S Austria Technologie & Systemtechnik Aktiengesellschaft, 8700 Leoben (AT)
(72) Inventor: WAGNER, Christoph, 8282 Bad Loipersdorf (AT)
(74) Representative: Dilg, Haeusler, Schindelmann Patentanwaltsgesellschaft mbH

(57) **Abstract**

There is described an apparatus (100) for treating a portion of a surface of at least one electrically conductive layer structure (210) of a layer stack (201) of a printed circuit board or the like (200), wherein the apparatus (100) comprises a surface treatment unit (120), configured to alter along a predefined multi-profiled shape (250) a portion of the exposed surface of the at least one electrically conductive layer structure (210). Further, there is described a PCB or the like (200) and a method for treating a surface.

## Description

### Field of the Invention

The invention relates to an apparatus for treating a portion of a surface of at least one electrically conductive layer structure of a layer stack of a printed circuit board or the like. Further the invention related to the printed circuit board or the like with a multi-profile shaped portion. Additionally, the invention relates to a method of treating a portion of a surface of at least one electrically conductive layer structure of a layer stack of a printed circuit board or the like.

### Technological Background

In the context of growing product functionalities of electronic boards and increasing miniaturization of an electronic board such as printed circuit boards, increasingly more powerful packages are being employed, which have a plurality of contacts or connections, with smaller and smaller spacing between these contacts. In particular, electronic boards shall be mechanically robust and electrically reliable so as to be operable even under harsh conditions. Conventional approaches of forming electronic boards such as printed circuit board and the like are still challenging.

### Summary of the Invention

There may be a need to trace a PCB or the like in an efficient and reliable manner.

According to an exemplary embodiment of the invention, an apparatus, a printed circuit board or the like, and a method are described.

According to an exemplary embodiment, there is described an apparatus for treating a portion of a surface of at least one electrically conductive layer structure (e.g. a metal surface, in particular a copper and/or silver layer structure) of a layer stack of an electronic board, in particular a printed circuit board or the like. The apparatus comprises a surface treatment unit, configured to alter along a predefined multi-profiled shape (e.g. defining an identification mark and/or a legend print) a portion (to provide a multi-profiled shaped portion) of the exposed surface of the at least one electrically conductive layer structure.

According to an exemplary embodiment, there is described an electronic board, in particular a PCB or the like, having a layer stack, comprising at least one electrically conductive layer structure (and in particular at least one electrically insulating layer structure). A main surface of the at least one electrically conductive layer structure comprises an altered portion (e.g. generated by the above-described apparatus) having at least one predefined multi-profiled shaped portion, defining an identification mark and/or a legend print.

According to an exemplary embodiment, there is described a method of treating a portion of a surface of at least one electrically conductive layer structure of a layer stack of an electronic board (in particular as described above), in particular a PCB or the like, the method comprising treating the PCB or the like by altering along a predefined multi-profiled shape a portion of the exposed surface of the at least one electrically conductive layer structure (in particular wherein (surface) treating comprises using a fiber laser).

In the context of the present application, the term "electronic board" may particularly denote any support structure with electric functionality. For example, the electronic board may be a printed circuit board (PCB) or the like. In some embodiments, the terms "electronic board" and "PCB or the like" may be used synonymously.

A "PCB or the like" may be a simple layer stack and does not necessarily need to carry any component. However, the electronic board may also be a component carrier. More generally, the electronic board or PCB or the like may also be an interposer or an IC (integrated circuit) substrate. The PCB or the like may or may not be capable of accommodating one or more components thereon and/or therein for providing mechanical support and/or electrical connectivity and/or thermal connectivity. In other words, a PCB or the like may be configured as a mechanical and/or electronic and/or thermal board, for instance but not necessarily also functioning as a carrier for components. A PCB or the like may comprise a laminated stack, such as a laminated layer stack. In particular, a PCB or the like may be one of a printed circuit board, an organic interposer, and an IC (integrated circuit) substrate. A PCB or the like may also be a hybrid board combining different ones of the above mentioned types of electronic boards. A PCB or the like may be flat or plate-shaped.

In the context of the present application, the term "PCB or the like preform" may particularly refer to an electronic board (in particular PCB or the like) under manufacture, i.e. a semi-finished product. In an example, such a PCB or the like preform may comprise two or more PCBs or the like under manufacture. After the manufacture process of the individual PCBs or the like, these may be separated (singularized) into the individual PCBs or the like. Such a PCB or the like preform may also be called a panel or simply a board. In an embodiment, at (each of) the individual PCBs or the like of the PCB or the like preform, a multi-profiled shaped portion may be formed. Additionally or alternatively, a multi-profiled shaped portion (master code) may be formed at the (top and/or bottom side) of the PCB or the like preform, in particular in an area free of the PCBs or the like.

In the context of the present application, the term "stack" may particularly denote a flat or planar sheet-like body. For instance, the stack may be a layer stack, in particular a laminated or rolled layer stack. Such a laminate may be formed by connecting a plurality of layer structures by the application of mechanical pressure and/or heat. Preferably, the plurality of layer structures are aligned parallel on top of each other. The stack may comprise electrically conductive structures and at least one electrically insulating structure.

In the context of the present application, the term "layer structure" may particularly denote a continuous layer, a patterned layer or a plurality of nonconsecutive islands within a common plane, and it may perform the function of electrical conductivity and/or electrical insulation. A layer structure may also comprise an interconnection structure which protrudes from a planar surface of the layer structure.

In the context of the present application, the term "electrically conductive layer structure" may particularly denote a layer structure as defined above that is (at least partially) electrically conductive; in other words, comprises or consists of an electrically conductive material. In a preferred example, the electrically conductive material is a metal, yet other conductive materials can also be applicable. In embodiments, the electrically conductive layer structure may be configured e.g. as a conductor track, a via, or a coating. In an example, the electrically conductive layer structure may be configured as a copper layer, in particular arranged on an electrically insulating layer structure. Such a copper layer may for example be plated or rolled out. In a further example, the electrically conductive layer structure may be configured as a surface coating, e.g. (immersion) silver. In an embodiment, the electrically conductive layer structure may comprise two or more stacked electrically conductive layers. For example, an exposed one of the stacked electrically conductive layers may be a surface coating layer. Further, another one of the electrically conductive layers may be arranged (directly) below the exposed electrically conductive layer. Hereby, the other electrically conductive layer may be (significantly) thicker than the exposed other one of the electrically conductive layers.

In the context of the present application, the term "multi-profiled shaped portion" may particularly denote a physical structure formed in a (main) surface of a PCB or the like. In particular, a multi-profiled shaped portion may comprise varying profiles or contours, so that areas/regions of the multi-profiled shaped portion may differ e.g. in height, width, or shape. In an example, a multi-profiled shape portion may be a simple form, for example a square or a circle. In a further example, the multi-profiled shape portion may comprise a distorted shape (of the simple form, e.g. jagged). In a further example, a multi-profiled shape may comprise a plurality of multi-profiled shaped portions. Thus, a multi-profiled shape may be a much more complex structure than a general labelling. Accordingly, specialized manufacture methods would have to be applied in order to generate such a multi-profiled shaped portion and/or a multi-profiled shape.

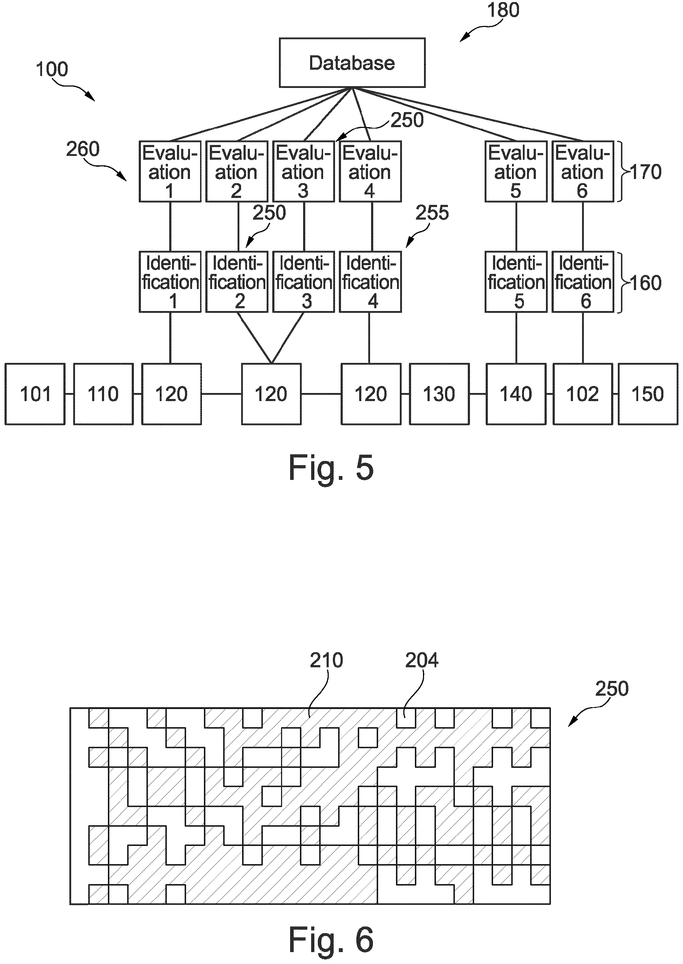

In a preferred embodiment, the multi-profiled shape may be configured as an identification mark and/or a legend print; for example a data matrix code (see also examples listed below and the example of Figure 6). In this manner, even complex identification marks with a plurality of information (and eventually explanation of the coding) may be provided. In an example, the multi-profiled shape may be formed in an electrically conductive layer structure, in particular in at least one of two stacked electrically conductive layers. Thereby, PCB or the like and/or PCB or the like preforms may be made traceable in an efficient and reliable manner.

In context of the present application the term "to alter along a predefined multi-profiled shape" may denote a process to create a multi-profiled shape and/or a multi-profiled shaped portion. Thus, the apparatus may alter the surface, in particular the exposed surface, of the electrically conductive layer structure of the stack along a predefined virtual line and/or pattern and/or area. In an example, the term "to alter along a predefined multi-profiled shape" may comprise a process comprising a single treatment step. The single treatment step may be, for example, a plasma process or a laser process or a wet chemical etching process. Additionally or alternatively, the single process step may create the multi-profiled shape within one treatment step. For example, a (single) laser applied one shot to the surface and moves then along the surface. In another example, the term "to alter along a predefined multi-profiled shape" may comprise a process comprising a plurality treatment steps. The plurality of treatment steps may be for at least two plasma processes or at least two laser processes or at least two wet chemical etching processes or a combination of at least one or the processes listed before. Additionally or alternatively, plurality of treatment steps may create the multi-profiled shape in a plurality of treatment steps, since within one treatment step a respective multi-profiled shaped portion is created and a plurality of multi-profiled shaped portions create a multi-profiled shape. For example, a plurality of lasers and/or laser shots are applied and respectively moved along the surface.

According to an exemplary embodiment of the invention, a PCB or the like can be traced in an efficient and reliable manner, when a portion of the exposed surface of at least one electrically conductive layer structure of the PCB or the like is altered along a predefined multi-profiled shape to thereby form the multi-profiled shaped portion (and/or the multi-profiled shape) (defining an identification mark and/or a legend print) in the main surface of the PCB or the like.

Conventionally, circuit boards may be labelled with a simple code, for example using e.g. silkscreen printing, inkjet printing, or laser labeling. In the last case, a simple label may be written into a resin layer or a solder resist. However, these conventional examples refer to rather simple labels and focus on electrically insulating materials.

It has been found by the inventors that tracing, specifically in the context of exposed electrically conductive material at the surface of the PCB or the like, may be made more efficient and reliable, when a complex code (a multi-profiled shape) is used that can include a plurality of information. Providing such a complex physical structure may not be straightforward; for example a carbon dioxide laser is not configured to drill through a copper layer.

However, in an embodiment, it has been shown that the whole procedure of altering the surface of a PCB or the like and identification/evaluation of the formed multi-profiled shaped portion may be done highly efficiently in a respective apparatus, preferably completely automatized in a (cost-) efficient manner.

### Detailed Description of Exemplary Embodiments

In the following, further exemplary embodiments of the apparatus, the PCB or the like and the method will be explained.

In an embodiment, the multi-profiled shape is configured as an identification mark and/or a legend print. In this context, an identification mark(er) may be understood as any structure/shape that allows an (individual/unique) identification of a PCB or the like and/or a PCB or the like preform (such as a panel with a plurality of PCB or the like that will be separated later-on). Further in this context, a legend print may be understood as a key or guide that explains marks such as visual elements, in particular symbols, numbers, lines, colors, etc. In an example, a legend print may explain how to read the (parts of the) identification marker. Such a legend print may help/support the (automatic) reader to understand the meaning of these visual elements. In a preferred embodiment, the identification mark and/or a legend print comprises a plurality of information, thus being much more complex than a conventional label.

In an embodiment, the multi-profiled shape may comprise at least one of a barcode, a patterned code, an optically readable code, a QR-Code, a VS-code, a data matrix code, a semacode, a beetagg, a vericode, a maxicode, an aztec-code, a visual element. This may provide the advantage that well-established code-schemes may be directly applied. In particular, these codes (the list is merely an example and not limiting) may be especially suitable to be visually read, specifically automatically read by a machine. In such a code, e.g. a DMC (data matrix-code), a plurality of information may be encoded, e.g. batch number, position in panel, day/time of manufacture, manufacture conditions, machine(s) to manufacture the PCB or the like, intended purpose, system used to write the code, etc. Accordingly, a plurality of important information may be directly encoded, thereby supporting the manufacture process and also traceability during the whole lifetime of a product.

In an embodiment, the surface treatment unit is further configured to: manipulate/change the surface structure of the electrically conductive layer structure. This may provide the advantage that the multi-profiled shaped portion and/or the multi-profiled shape may be formed in a straightforward and irreversible manner.

In an embodiment, at least one of the following properties may be manipulated/changed: roughness, reflection, chemical composition, color, conductivity. This may render the manufacture process and the information to be transported very flexible. Removing material of the surface of the PCB or the like may enable the provision of a plurality of options. For example, removing a part of a copper layer may result in a rough surface. Thereby, not only readable information may be provided in the surface, but also the formation process may be traceable. In a further example, altering the surface may be done using etching, thereby changing the chemical composition. In a specific embodiment, a roughening of the surface (e.g. by a laser process) may be around 0.5 µm to 3 µm.

In an embodiment, the surface treatment unit comprises a chemical treatment unit. For example, the surface may be treated/altered using etching. In an embodiment, the surface treatment unit comprises a temperature treatment unit, e.g. providing a high temperature to the surface. In an embodiment, the surface treatment unit comprises a plasma treatment unit or a laser treatment unit. In a preferred embodiment, the surface treatment unit comprises a fiber laser treatment unit. A plasma treatment unit and a laser treatment unit may be understood as a temperature treatment unit, since the temperature of the surface is elevated using these methods. In an example, plasma treatment can be considered as a chemical treatment, e.g. when it used for as surface activation. In a further example, plasma treatment can also be considered as a physical treatment, e.g. when it used for cleaning.

A fiber laser may be understood as a type of laser where the active gain medium is an optical fiber doped with rare-earth elements like erbium, ytterbium, or neodymium. These lasers may generate highly focused, powerful light beams and may be highly efficient and precise. Fiber lasers may be used in applications like cutting, welding, and marking; specifically due to their durability, low maintenance, and ability to operate at high power levels. Hence, a fiber laser may be especially advantageous for the present application of surface treatment by generating a multi-profiled shaped portion.

In an embodiment, the layer stack comprises (at least) two stacked electrically conductive layers. In an embodiment, one of the stacked electrically conductive layers is exposed. In an embodiment, the surface treatment unit is configured to remove at least partially the exposed stacked electrically conductive layer. Alternatively, the surface treatment unit may be configured to change at least partially the exposed stacked electrically conductive layer. In an embodiment, the surface treatment unit is further configured to remove (also) a part of the other stacked electrically conductive layer. This may provide the advantage that the multi-profiled shaped portion and/or the multi-profiled shape may be provided in an efficient and robust manner by removing material of an exposed layer.

In a first example, only part of the exposed layer may be removed. In a second example, a part of the other layer below the exposed layer may be exposed by the material removal. In this case, also the other layer below the exposed layer may be treated by material removal. In this manner, there are more design options for providing the code. For example, specific information may be encoded by also drilling into the other stacked electrically conductive layer.

In an embodiment, the exposed layer is (at least partially) removed and the other layer below may be processed/changed. In an example, the exposed layer may be (at least partially) removed and the other layer may be physically changed, e.g. by roughening the surface. In another example, the exposed layer may be (at least partially) removed and the other layer may be chemically changed, e.g. by oxidation. In an embodiment, this may especially be the case, when the exposed layer and the other layer comprise a different material.

In an embodiment, the exposed stacked electrically conductive layer comprises or consists of a different material, in particular silver, as the other stacked electrically conductive layer, in particular copper. This may provide the advantage that the stacked electrically conductive layer structure may be used in a flexible manner, for example the exposed stacked electrically conductive layer may function as a protection/coating layer, while the other stacked electrically conductive layer(s) may be applied for the intended electronic application, i.e. an inverter functionality.

In an embodiment, the thickness of the exposed stacked electrically conductive layer is 0.5 µm or less, in particular 0.25 µm or less, more in particular 0.1 µm (100 nm) or less. In other words, the exposed stacked electrically conductive layer (silver layer) is extremely thin and formed as a coating for the other stacked electrically conductive layer(s) below. For example, the coating may be configured as a protection against corrosion. Accordingly, it may be required that the multi-profiled shape and/or the multi-profiled shaped portion is formed with a high degree of precision, especially when formed only in the exposed stacked electrically conductive layer.

In an embodiment, the surface treatment unit is further configured to alter a multi-profiled shaped portion and/or a multi-profiled shape having an extension defining at least one closed boundary profile within the planar extension of the exposed surface of the at least one electrically conductive layer structure. In an embodiment, the surface treatment unit is configured to alter a multi-profiled portion and/or a multi-profiled shape having an extension defining several multi-profiled sub-portions, in particular wherein the association thereof defines an identification mark and/or a legend print. This may provide the advantage that a flexible and reliable traceability is provided. In an example, the multi-profiled shape may comprise two or more multi-profiled shapes and/or two or more multi-profiled shaped portions, thereby making the PCB or the like (preform) better traceable; e.g. more information may be encoded in this manner. The multi-profiled shape may comprise a frame structure that (at least partially) surrounds the (two or more) multi-profiled shapes and/or the (two or more) multi-profiled shaped portions.

In an embodiment, the surface treatment unit comprises (is divided into) two or more sub-areas, which may be preferably (physically) separated. Thereby, efficiency and/or flexibility may be enhanced. In an example, a first area is doing a first identification check in the first place. The first area may also be used to remove the separation foil after loading the panel. In a further example, a second area is doing the laser process in the second place. In an embodiment, the areas are separated since the surface treatment (e.g. laser process) may create particles which may contaminate other panels and/or other areas of the apparatus.

In an embodiment, the apparatus comprises a loading unit, configured for loading the PCB or the like (preform) into the apparatus. Thereby, the PCB or the like (preform) may be provided for the further processing in an efficient (preferably automated) manner. For example, the loading unit may be configured as a conveyor belt or another structure that enables an automatic loading of the PCB or the like (preforms). The loading unit may be configured to separate the PCB or the like (preform) from other elements, for example a host element for the PCB or the like and/or a separation element, for example a foil.

In an embodiment, the apparatus comprises an unloading unit, configured for unloading the PCB or the like (preform) from the apparatus. Thereby, the processed PCB or the like (preform) may be provided for the further processing (in particular packaging) in an efficient (preferably automated) manner. For example, the unloading unit may be configured as a conveyor belt or another structure that enables an automatic unloading of the processed PCB or the like (preforms).

In an embodiment, the apparatus comprises or is configured to be coupeable to a unit for applying an electrically conductive layer, in particular the exposed stacked electrically conductive layer. In an example, the unit for applying an electrically conductive layer may be an electrochemical plating unit and/or a wet chemical unit. This may bring the advantage to directly insert the PCB or the like into the apparatus without an additional transfer.

In an embodiment, the apparatus is divided into a plurality of processing areas. Preferably each processing area is (physically) at least partially separated from each other. The handling unit may be configured to transfer the PCB or the like from one processing area to another processing area. This may provide the advantage of having parallel processing steps within each area which in fact shortens the manufacturing time of the PCB or the like. In an example, the respective processing areas may be connected to each other by an opening, e.g. a door.

In an embodiment, the apparatus comprises a checking area. After one identification and/or evaluation step the PCB or the like may be transferred to the checking area. If an error occurs and an automatically production may not be continued, the PCB or the like may be transferred to the checking area and an operator may be consulted. In an example, the checking area may be connected to each processing area of the apparatus (by the handling unit). A validation check and/or a visual inspection may be applied at the checking area.

In an embodiment, the apparatus comprises at least two surface treatment units. This may shorten the production time of the PCB or the like.

In an embodiment, the apparatus comprises a buffering unit, configured for temporarily storing the PCB or the like (preform). Thereby, an efficient organization may be enabled. In an example, the buffering unit may be coupled with the loading unit. In a further example, the buffering unit may comprise one or more housing elements, e.g. trays, for temporarily storing the PCB or the like.

In an embodiment, the apparatus comprises an identification unit, configured for identifying an identification structure, in particular a fiducial, of the PCB or the like and/or the multi-profiled shape and/or the multi-profiled shaped portion. This may provide the advantage that the PCB or the like (preform) may be efficiently inspected, in particular automatically. Further, the inspection may be used as a quality control of the PCB or the like and/or the formed multi-profile shape(s). For example, the identification unit may (automatically) identify an alignment marker (fiducial) of the PCB or the like (preform). Thereby, the PCB or the like may be efficiently aligned for surface treatment. Further, an initial identification marker (from a previous process, e.g. etching or plating) may be (automatically) inspected. Thereby, the PCB or the like (preform) may be identified/verified, for example as a known-good part and/or as a known-bad part. In a further example, the identification unit may (automatically) control the quality of the formed multi-shaped profile and/or the multi-profiled shaped portion. Still in another example, the identification unit may (automatically) control the quality of the surface of the PCB or the like, e.g. scratches may be identified. In an example, the apparatus may comprise a plurality of identification units, preferably each processing area comprises a separate identification unit. Alternatively, one identification unit may do all identification processes at the different processing areas, since the identification unit is movable.

In an embodiment, the apparatus comprises an evaluation unit, configured for evaluating at least one information, preferably an image, provided by the identification unit. This may provide the advantage that the PCB or the like (preform) may be reliably evaluated, in particular automatically. In an example, the identification unit and the evaluation unit may be coupled, so that information obtained by the identification unit (e.g. by taking an image) may be evaluated. For example, an initial identification marker may be evaluated for recognizing the used PCB or the like. In a further example, the formed multi-profile shape and/or the multi-profiled shaped portion may be evaluated regarding quality and/or traceability.

Hereby, the initial identification marker is different to the multi-profiled shape (applied by the surface treatment process). In particular, the electrically insulating layer is exposed in case of the initial identification marker and/or said marker is formed in the electrically insulating layer. The multi-profiled shape in turn is formed in an electrically conductive layer, exposed after the surface treatment process.

In an embodiment, the apparatus comprises a database (and/or a coupling/connection to a database) configured for storing information of the PCB or the like. This may provide the advantage that the PCB or the like processing may be efficiently and reliably organized (automatically). In an example, the database may be implemented directly in the apparatus. In another example, the database may be remote of the apparatus and coupled in a wireless or wired manner with the apparatus. The database may for example store information regarding (each of) the PCB or the like (preform) to be processed/manufactured. In this manner, the PCB or the like loaded to the apparatus may be automatically identified, evaluated and cross-checked with the database. In an example, the evaluation comprises a comparison with the database. In a further example, the database is coupled to the evaluation unit. The database may further comprise information regarding the multi-profiled shape and/or the multi-profiled shaped portion to be altered in the surface of the PCB or the like. Thereby, an identification mark and/or legend print may be reliably provided/organized.

In an embodiment, the apparatus comprises a packaging unit, configured for packing the PCB or the like (in particular a final product) into a hosting element. This may provide the advantage that the processed PCB or the like can be directly (still in the processing apparatus) packaged into a (final) application element, in particular automatically. In an example, the PCB or the like may be used in an inverter element. In an example, the packaging unit may arrange a plurality of PCBs or the like in a hosting element. Preferably, the plurality of PCBs or the like are arranged in stack thickness direction one above the other. The PCBs or the like may be separated from each other by a separation layer, for example a foil. Additionally or alternatively, the plurality of PCBs or the like may be arranged laterally next to each other.

In an embodiment, the apparatus comprises a labeling unit, configured for labeling the PCB or the like and/or a housing element (e.g. tray) and/or the hosting element, e.g. with a sticker. In an example, the labelling unit is configured for providing an identification mark on the tray in order to know which PCB or the like is hosted in the tray; this may provide further information (delivery units in package for customer shipment, quantity of products with defects, etc.).

In an embodiment, the apparatus comprises a handling unit, configured for handling the PCB or the like (preform). This may provide the advantage that the PCB or the like (preform) may be handled within the apparatus automatically, thereby saving time and making the processing more efficient. For example, the handling unit may be configured to transport the PCB or the like between two or more units (and/or processing areas and/or sub-areas) of the apparatus, e.g. between a loading/buffering unit and the surface treatment unit. Further, the handling unit may be configured to turn/flip the PCB or the like (preform), for example to alter a first main surface (top side) in the first place, and then to alter a second main surface (bottom side) of the PCB or the like preform in the second place. Thereby, less devices would be needed, for example one laser device may be used instead of two opposite laser devices. In an embodiment, the handling device may be configured for example as a robot arm.

In an embodiment, the apparatus comprises at least two sub-sections, wherein different process steps are related to a respective sub-section. A sub-section may comprise in an example one or more of the above described units. In an embodiment, the handling unit is located between the two sub-sections (e.g. units), and configured to move the PCB or the like (preform) from one sub-section to the second sub-section. In a specific embodiment, the handling unit is located between the loading unit and/or the unloading unit and one of the sub-sections. Thereby, a (completely) automatic processing in the apparatus may be enabled. By moving the PCB or the like by the handling unit, no human interaction may be required.

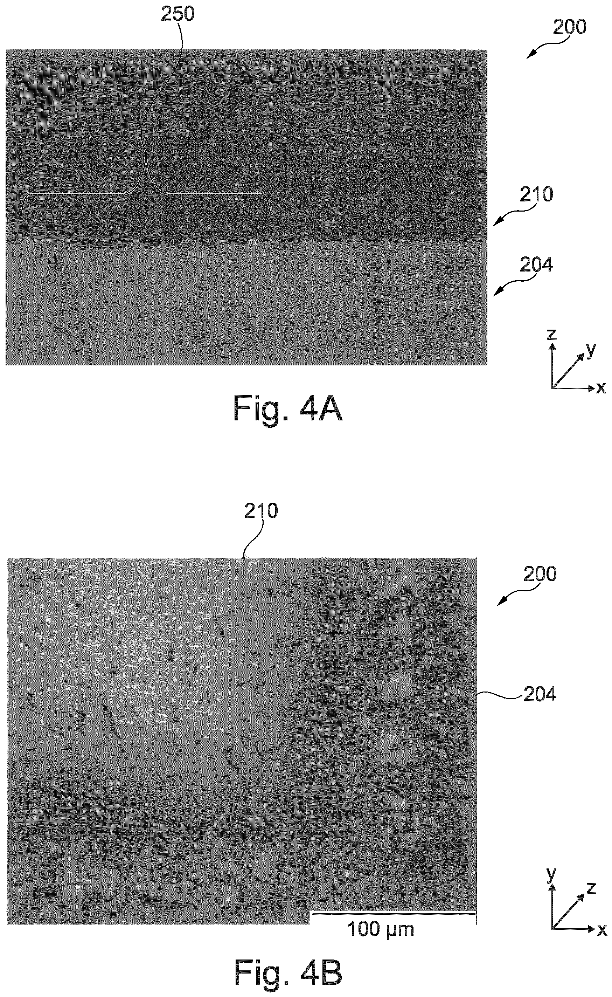

In an embodiment, the altered portion has a surface characteristic different than that one of the remaining surface structure of the electrically conductive layer structure. In an embodiment, the surface characteristic is at least one of the following: a roughness, a reflection, a chemical composition, a color, a conductivity. Thus, the process of forming the multi-profiled shape may be traces back in a final product. For example, the roughness of a copper layer may be significantly increased, when being treated by a (fiber) laser (compare Figure 4B).

In an embodiment, the at least one electrically conductive layer structure comprises two stacked electrically conductive layer structures. In an embodiment, the altered portion comprises an at least partial removal of the external one of the two stacked electrically conductive layers. In an embodiment, the altered portion further comprises a partial removal of the other stacked electrically conductive layer. Depending on the desired application, the multi-profiled shape may be provided in a flexible manner, i.e. by removing only part of one layer or by removing parts of two or more layers.

In an embodiment, the multi-profiled shape(-d portion) is defined by the profile of the un-removed portion of the external/exposed one of the two stacked electrically conductive layers. In this embodiment, the multi-profiled shape(-d portion) may be formed only by the (remaining) part of the exposed stacked electrically conductive layer. This may provide the advantage that the layers below are (essentially) not affected and the multi-profiled shape may be formed only in a coating layer, especially in an ultra-thin layer (less footprint).

In an embodiment, the external/exposed one of the two stacked electrically conductive layers has a different material, in particular silver, than the other stacked electrically conductive layer, in particular copper.

In an embodiment, the external/exposed one of the two stacked electrically conductive layers has a smaller thickness, in particular 0.5 µm or lower, in particular 0.1 µm or lower, than the other stacked electrically conductive layer.

In an embodiment, the altered portion comprises a multi-profile shape and/or the multi-profiled shaped portion having an extension defining at least one closed boundary profile within the planar extension of the external surface of the at least one electrically conductive layer structure. In an embodiment, the altered portion has an extension defining several multi-profiled sub-portions, in particular wherein the association thereof defines an identification mark and/or a legend print. This may bring the advantage of creating an identification mark and/or legend print having defined shape with high resolution, which enables an errorless identification of the identification mark and/or legend print.

In an embodiment, the stack comprises at least one electrically insulating layer structure. In an embodiment, the electrically insulating layer structure comprises a flexible material, in particular polyimide. In an embodiment, the PCB or the like is flexible. Such a configuration may be advantageous for a plurality of applications, e.g. when the PCB or the like is to be bent or even rolled in a hosting element. The flexibility may be enhanced by a flexible insulating material such as polyimide.

In an embodiment, the electrically conductive layer structure (e.g. as a plating layer) is arranged directly on said electrically insulating layer structure, in particular on a lateral surface and/or on a main surface of said electrically insulating layer structure. Such a plating layer may be formed at least partially by electroless plating, for instance by sputtering, which may also allow to cover a dielectric surface.

In an embodiment, the PCB or the like is free of solder resist. This may provide the advantage that additional material and/or process steps may be obsolete, thereby saving costs and efforts. In an embodiment, the exposed stacked electrically conductive layer may serve as a coating/protecting layer. In an embodiment, there are no electrically insulating layer structures exposed at the surface of the PCB or the like, so that no solder resist is required.

In an embodiment, the electrically conductive layer structure comprises rolled metal, in particular copper. Such a layer may be rolled on a plastic layer (e.g. polyimide) for forming a stack. For certain special applications in the framework of the manufacture of electronic boards (such as a PCB or the like), rolled copper foils (so-called RA copper, i.e. "rolled annealed copper") are used.

In an embodiment, the electrically conductive layer structure, in particular the other one of the stacked electrically conductive layers, has a thickness of at least 80 µm, in particular of at least 100 µm. With such relatively thick electrically conductive layer structures, in particular copper sheets, stacks may be formed, e.g. by rolling on said metal sheets on an electrically insulating layer structure, such as a plastic foil.

In an embodiment, the PCB or the like further comprises a frame structure, wherein the multi-profiled shape and/or the multi-profiled shaped portion is arranged at least partially in the frame structure, in particular wherein the frame structure comprises a circumferential region that comprises a further altered surface encircling the multi-profile shape and/or the multi-profiled shaped portion. This may provide the advantage that the multi-profiled shape(s) may be well protected in a frame structure, preferably manufactured with the same method and/or within the same process.

In an embodiment, the apparatus comprises a filtering unit. In an example, the filtering unit may comprise an electrostatic precipitator and/or a centrifuge and/or a bag filter and/or a cartridge filter. The filtering unit may be configured to separate particles, in particular solid particles, preferably particles having a dimension in the range between 100 nm to 1 mm from gas inside the apparatus. This may bring the advantage of ensuring clean gas conditions inside the apparatus and thus may enhance the quality of multi-profile shape and/or the multi-profiled shaped portion creation since particles may interfere the multi-profile shape and/or the multi-profiled shaped portion formation by the surface treatment unit for example a fiber laser.

In an embodiment, the apparatus is configured electrostatic discharge (ESD) safe. In a further embodiment, the apparatus comprises an ESD safe unit. ESD during a manufacturing process resembles a high risk of damage to sensitive electronic devices. By providing a ESD safe area, security and efficiency of manufacture may be improved.

In an exemplary embodiment, the apparatus may comprise at least one of the following features/functionalities:
- Loading parts from housing elements (with separator foils),
- Check product traceability code (initial identification marker),
- Check yield status of PCB or the like (preform) with identification unit (good or bad),
- Entering a multi-profiled shape, preferably a DMC code, by laser ablation (multi-profiled shape depends on yield check) into electrically conductive layer, in particular exposed other electrically conductive layer; preferably, multi-profiled shapes provided on both (front and back) sides are linked,
- After entering multi-profiled shape on the PCBs or the like cards (there are a plurality, e.g. nine, cards on a panel), verification of multi-profiled shape can be required (code quality),
- Entering a main multi-profiled shape,
- Check of technical cleanness (cleaning of product depends on requirements),
- AVI check,
- Unload parts in trays (with separator foil),
- Labelling of tray with quality information,
- Storage of all related data in a database to fulfill traceability requirements,
- Unload tray to packaging area for further processing.

In an embodiment, the initial identification marker is different to the multi-profiled shape (applied by the surface treatment process). Initial: electrically insulating layer is exposed; multi-profiled shape: electrically conductive layer is exposed after the process.

In an embodiment, the electronic board is shaped as a plate. This contributes to the compact design, wherein the electronic board nevertheless provides a large basis for mounting components thereon. In particular a naked die as example for an electronic component can be surface mounted on a thin plate such as a printed circuit board.

In an embodiment, the electronic board is configured as one of the group consisting of a printed circuit board, a substrate (in particular an IC substrate), and an interposer.

In the context of the present application, the term "printed circuit board" (PCB) may particularly denote a plate-shaped electronic board which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). A printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small electronic board, in particular an IC substrate. An IC substrate may be, in relation to a PCB, a comparably small electronic board onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as electronic board comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board.

A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, Melamine derivates, Polybenzoxabenzole (PBO), bismaleimide-triazine resin, polyphenylene derivate (e.g. based on polyphenylenether, PPE), polyimide (PI), polyamide (PA), liquid crystal polymer (LCP), polytetrafluoroethylene (PTFE), Bisbenzocyclobutene (BCB) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the electronic board as electrically insulating structures.

In an embodiment, the at least one electrically conductive layer structure comprises at least one of the group consisting of copper, aluminum, nickel, silver, gold, palladium, tungsten, titanium and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component, which may be surface mounted on and/or embedded in the electronic board, can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (GazOs), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be surface mounted on the electronic board. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be an IC substrate, an interposer or a further electronic board, for example in a board-in-board configuration. The component may be surface mounted on the electronic board. Moreover, also other components, in particular those which generate and emit electromagnetic radiation and/or are sensitive with regard to electromagnetic radiation propagating from an environment, may be used as component.

In an embodiment, the electronic board is a laminate-type electronic board. In such an embodiment, the electronic board is a compound of multiple layer structures which are stacked and connected together by applying a pressing force and/or heat.

After processing interior layer structures of the electronic board, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or electronic board.

In particular, an electrically insulating solder resist may be applied to one or both opposing main surfaces of the layer stack or electronic board in terms of surface treatment. For instance, it is possible to form such a solder resist on an entire main surface and to subsequently pattern the layer of solder resist so as to expose one or more electrically conductive surface portions which shall be used for electrically coupling the electronic board to an electronic periphery. The surface portions of the electronic board remaining covered with solder resist may be efficiently protected against oxidation or corrosion, in particular surface portions containing copper.

It is also possible to apply a surface finish selectively to exposed electrically conductive surface portions of the electronic board in terms of surface treatment. Such a surface finish may be an electrically conductive cover material on exposed electrically conductive layer structures (such as pads, conductive tracks, etc., in particular comprising or consisting of copper) on a surface of an electronic board. If such exposed electrically conductive layer structures are left unprotected, then the exposed electrically conductive electronic board material (in particular copper) might oxidize, making the electronic board less reliable. A surface finish may then be formed for instance as an interface between a surface mounted component and the electronic board. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

The aspects defined above and further aspects of the invention are apparent from the examples of embodiment to be described hereinafter and are explained with reference to these examples of embodiment.

### Brief Description of the Drawings

Figure 1 illustrates an apparatus for treating a portion of a surface of a printed circuit board or the like, according to an exemplary embodiment of the invention.
Figure 2 illustrates a cross-sectional view of a printed circuit board or the like, according to an exemplary embodiment of the invention.
Figures 3A illustrates a top view, while Figure 3B illustrates a bottom view of a printed circuit board or the like preform, according to an exemplary embodiment of the invention.
Figure 4A illustrates a microscopic image of a cross-sectional view of the main surface of a printed circuit board or the like, and Figure 4B illustrates a microscope image of a top view on the main surface of the printed circuit board or the like, according to exemplary embodiments of the invention.
Figure 5 illustrates a method of processing a printed circuit board or the like, according to an exemplary embodiment of the invention.
Figure 6 illustrates schematically a top view on a multi-profiled shape configured as a patterned code, according to an exemplary embodiment of the invention.

### Detailed Description of the Drawings

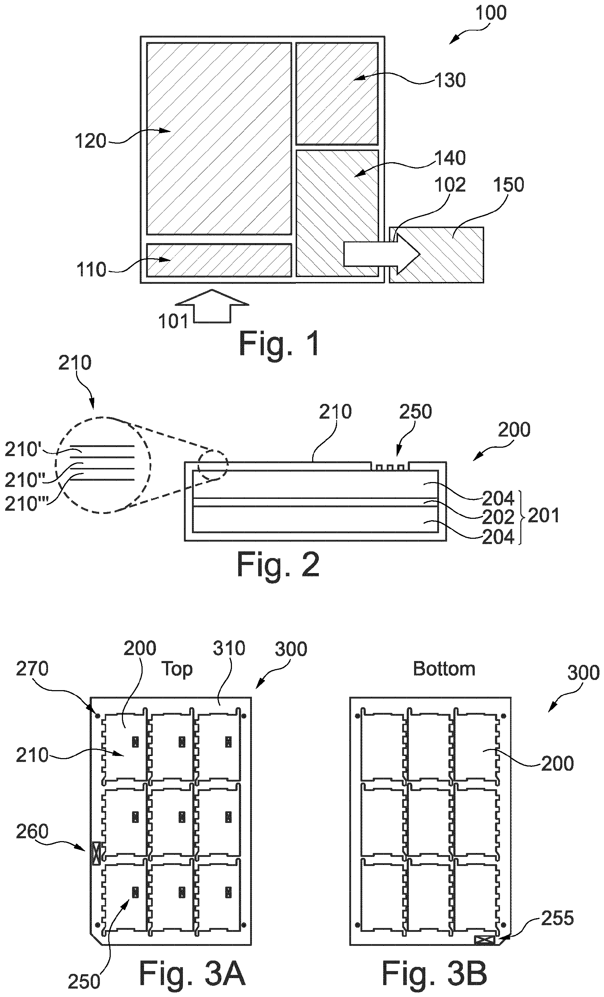

**Figure 1** illustrates an apparatus 100 for treating a portion of a surface of a printed circuit board or the like, according to an exemplary embodiment of the invention. The apparatus 100 comprises a loading unit 101 for loading a PCB or the like 200 (under manufacture), i.e. a PCB or the like preform, a so-called panel, into the apparatus 100. The loading unit 101 may be configured for example as a conveyor belt and/or a robotic arm or another device that automatically loads the PCB or the like 200 into the apparatus 100. The loading unit 101 can be coupled to a buffering unit 110 (e.g. product buffering with tray), where the PCB or the like 200 products can be stored/collected temporally. For example, the buffering unit 110 can comprise a plurality of trays for storing panels for a limited time. Preferably, the tray can comprise a specific pattern at the bottom that fits to a corresponding pattern of the PCB or the like preform.

The apparatus 100 further comprises a surface treatment unit 120, here coupled to the buffering unit 110. The PCB or the like 200 (semi-finished) products can be temporarily stored (buffered) in the buffering unit 110 before being made subject to the surface treatment process. The surface treatment unit 120 is configured to alter along a predefined multi-profiled shape 250 (an identification mark and/or a legend print) a portion of the exposed surface of at least one electrically conductive layer structure 210 of the PCB or the like 200 (compare Figures 2 and 4 for details). Particularly, the surface treatment unit 120 is configured to manipulate/change the surface structure of the electrically conductive layer structure 210 regarding for example roughness, reflection, chemical composition, color, or conductivity.

For this purpose, the surface treatment unit 120 comprises a chemical treatment unit and/or a physical treatment unit (e.g. a temperature treatment unit and/or a mechanical treatment unit and/or a plasma treatment unit). In a specific example, the surface treatment unit 120 comprises a fiber laser treatment unit for providing a laser to alter the along the predefined multi-profiled shape a portion of the exposed surface (laser drilling). Hereby, the surface treatment unit 120 preferably removes a part of an exposed (one of stacked) electrically conductive layers 210, e.g. a silver layer. Yet, the surface treatment unit 120 can also remove (material from) another stacked electrically conductive layer (below the exposed layer) 204, e.g. a copper layer.

After being processed by the surface treatment unit 120, the PCB or the like 200 comprises at least one multi-profiled shaped portion and is further transferred to a (technically) clean area, e.g. a clean room, of a cleaning unit 130. Herein, the PCB or the like 200 can be cleaned at the clean area from the cleaning unit 130 for further processing, e.g. using ionized air provided by a nozzle and/or rinsing water.

The apparatus 100 further comprises an unloading unit 102 for unloading the processed PCB or the like 200 from the apparatus 100. The unloading unit 102 may be configured for example as a conveyor belt and/or a robotic arm or another device that automatically unloads the PCB or the like 200 from the apparatus 100. Before or after the unloading unit 102, there can be provided a separating unit that separates the individual PCB or the like 200 from the common PCB or the like preform 300 (panel). Further, the separating unit may provide a cutting mechanism or a dicing mechanism.

The unloading unit 102 can be further coupled to a packaging unit 150. In the packaging unit 150, the PCB or the like 200 can be assembled (with other electronic components) to provide an electronic product, for example an inverter. Additionally or alternatively, the packing unit 150 may be configured for packing the PCB or the like (in particular a final product) into a hosting element. In an example, the packaging unit 150 may arrange a plurality of PCBs or the like in a hosting element. Preferably, the plurality of PCBs or the like are arranged in stack thickness direction one above the other. The PCBs or the like may be separated from each other by a separation layer, for example a foil. Additionally or alternatively, the plurality of PCBs or the like may be arranged laterally next to each other.

The apparatus 100 can further comprise a labelling unit 140 configured to label (e.g. with a sticker) the processed PCB or the like 200 tray, so that it is easy identifiable which PCB or the like 200 is in which tray. In an embodiment, the labelling unit 140 is configured to label (e.g. with a sticker) the tray which stores the processed PCB or the like 200, so that it's easy to identify the allocation of PCB or the like 200 in tray from the label (comprising multiple identification information of the processed PCB or the like 200 in tray), and preferably a tracing arrangement (e.g a combination of an identification unit and an evaluation unit) can be configured to trace the correlation between tray and PCB or the like 200 based on said label.

The apparatus 100 can comprise further units such as an identification unit and an evaluation unit (not specifically shown). In a preferred embodiment, the apparatus 100 is configured to process the PCB or the like (preform) (surface treatment, verification, packaging) automatically, in particular without human interaction required.

**Figure 2** illustrates a cross-sectional view of a printed circuit board or the like 200, according to an exemplary embodiment of the invention. The PCB or the like 200 comprises a layer stack 201 with an electrically insulating layer structure 202 and two or more electrically conductive layer structures 210. In this example, the electrically insulating layer structure 202 is a resin, e.g. polyimide, sandwiched between two electrically conductive layer structures 204, e.g. copper. The copper layers 204 can be plated or rolled onto the electrically insulating layer structure 202. The PCB or the like 200 further comprises an exposed stacked electrically conductive layer 210 on top of another stacked electrically conductive layer 204. In one example, said exposed electrically conductive layer 210 is an extremely thin coating, e.g. made of (chemical/immersion) silver as a special protection layer. Alternatively, the exposed electrically conductive layer 210 may comprise chromium and/or nickel and/or gold. In an example, shown in detailed view, the exposed electrically conductive layer 210 comprises a plurality of stacked electrically conductive layers 210', 210", 210"'. In an example, at least one of the plurality of stacked electrically conductive layers 210', 210", 210‴ may differ in thickness of at least 50%, in particular at least 100% of the other one of the plurality of stacked electrically conductive layers 210', 210", 210‴. In another example, at least one of the plurality of stacked electrically conductive layers 210', 210", 210‴ may differ in a material and/or material composition compared to the other one of the plurality of stacked electrically conductive layers 210', 210", 210‴. In an example, the electrically conductive layer 210 may be located on a sidewall of the PCB or the like 200. Alternatively, the electrically conductive layer 210 may be located on the main surface of the PCB or the like 200 only. In the present context, the term "main surface" may in particular refer to a surface (in particular exposed surface) of the PCB or the like with the largest extension. Since a PCB is generally planar, there may be two opposed main surfaces, in particular oriented along the x- and y-axes.

In an embodiment, at least a part of the side walls of the PCB or the like 200 may not be covered by electrically conductive material. Figure 2 may depict a segment of a PCB or the like 200 delimited on the sides by vertical through connections (for example a mechanical through hole).

It can be seen that a portion of the exposed surface of the electrically conductive layer structure 210 has been altered along a predefined multi-profiled shape 250 by the surface treatment unit 120, thereby providing a multi-profiled shape 250 and/or a multi-profiled shaped portion. As a result, the exposed electrically conductive layer 210 has been partially removed in this area, thereby now forming an identification mark and/or a legend print. In the multi-profiled shape 250 (region), the other stacked electrically conductive layer 204 (below the exposed stacked electrically conductive layer 210) is now (at least partially) exposed (see detailed view in Figure 4). Due to the thermal treatment, at least a portion of the surface of the electrically conductive layer 210 may be eroded. Another portion, which was not treated by the thermal treatment, may create a multi-profiled shaped portion. Preferably, a plurality of multi-profiled shaped portions, which are in close proximity to each other may form a multi-profiled shape 250.

**Figure 3A** illustrates a top view of a PCB or the like preform 300 under manufacture, according to an exemplary embodiment of the invention. It is seen a semi-finished product 300 configured as a panel that comprises a plurality (here nine) of PCB or the like 200 under manufacture. In the present example, the top view is on a silver layer as the exposed stacked electrically conductive layer 210. It can be seen that each PCB or the like 200 comprises an initial identification marker 260, here a data matrix code (DMC). The initial identification marker 260 is to identify the panel 300 as such by the apparatus 100 and has been added beforehand, e.g. in a plating process. Additionally, the panel comprises four alignment markers 270 (e.g. fiducials) in the respective corners of the panel, e.g. for alignment during the surface treatment process and/or in a tray.

Further, after performing the surface treatment, each PCB or the like 200 of the PCB or the like preform 300 comprises an individual identification mark 250, here a data matrix code (DMC), provided by the respective multi-profile shaped portion and/or the multi-profiled shape 250. In an example, the multi-profiled shape and/or the multi-profiled shaped portion may be provided by a surface treatment unit 120 comprising a fiber laser. In an example, the fiber laser may have a configuration having a pulse frequency in the range from 1 kHz to 250 kHz, in particular in the range from 10 kHz to 150 kHz and/or a pulse duration in the range from 500 ps to 500 ns, in particular in the range from 1 ns to 300 ns. In another example, the multi-profiled shape and/or the multi-profiled shaped portion may be provided by a surface treatment unit comprising a plasma generation unit (configured for cleaning a PCB or the like 200 and removing the residue after performing the surface treatment).

**Figure 3B** illustrates a bottom view of the PCB or the like preform 300 under manufacture, according to an exemplary embodiment of the invention. As the individual identification mark 250 have been formed in the individual PCB or the like 200 at the top side, they cannot be seen at the bottom side. However, a master identification mark 255 for the whole panel 300 (the plurality of PCB or the like 200) has been formed by the surface treatment unit 120 in an area 310 outside of the PCB or the like 200 areas. For this purpose, the surface treatment unit 120 can either comprise two laser units (one above and one below) or may flip the panel 300 during the process, e.g. using a handling unit such as a robot arm.

**Figure 4A** illustrates a microscopic image of a cross-sectional view of the main surface of a printed circuit board or the like 200, according to an exemplary embodiment of the invention. In this image, the other stacked electrically conductive layer 204 is shown, here a copper layer. On top of said layer 204, there is arranged the exposed stacked electrically conductive layer 210, here a silver layer. Yet the last is too thin to be seen in this microscopic image, having a thickness of 250 nm or lower. The multi-profile structure 250 can be clearly seen that forms an identification mark (when seen from above for example, in a color change). It can be further seen that the laser has removed not only the exposed stacked electrically conductive layer 210 but also partially the other stacked electrically conductive layer 204 below, thereby significantly roughening the copper layer surface 204. In an example, the surface roughness of the copper layer surface 204 may be in the range from 0.5 µm to 3 µm, whereas the surface roughness of the silver layer may be in the range from 40 nm to 300 nm.

**Figure 4B** illustrates a microscopic image of a top view on a boundary between the exposed stacked electrically conductive layer 210 (here silver) and the other stacked electrically conductive layer 204 (here copper) below. On top of the other stacked electrically conductive layer 204, the exposed stacked electrically conductive layer 210 has been removed by laser ablation. The other stacked electrically conductive layer 204 is now exposed and a rough surface can be clearly seen as a relic of the laser treatment process.

**Figure 5** illustrates a method of processing a printed circuit board or the like 200 (preform 300) (under manufacture), according to an exemplary embodiment of the invention, e.g. using the apparatus 100 described above. In the first place, parts from previous working processes (e.g. plating) are delivered (e.g. in a tray with slip sheets and/or separation foil). The PCB or the like 200 under manufacture are organized as a panel 300 with a silver-covered surface and an initial DMC identification marker 260. This code 260 can expose the electrically insulating layer structure 202 below and is generated for example by plating or (re-) etching.

Said panels 300 can be loaded to the apparatus 100 by the loading unit 101 and temporarily stored in the buffering unit 110. Trays can be loaded automatically or manually in the buffering system, e.g. a storage shelf. The panels (in a tray) can be automatically loaded from the buffering unit 110 to the laser treatment process in the surface treatment unit 120. The trays can be separately stored in the apparatus 100. In the first place, foils can be separated. In case it is needed, a flipping/turning of the panel 300 can be done (e.g. using the handling unit).

A validation check can be performed at this stage (at a check station) based on the initial identification marker 260, e.g. check panel/board 300 for batch including a material check. The validation check may be done by a first identification unit 160, for example a camera, optionally in combination with a first evaluation unit. A further check may refer to the presence of any additional marker (there should be none). Then, a transfer from the check station to the laser treatment (surface treatment unit) 120 is done (for example from a first sub-area to a second sub-area). Alignment for the laser treatment can be based e.g. on the alignment markers 270. In between, a further identification check can be done by a further identification unit 160 optionally in combination with a further evaluation unit, e.g. to know which of the plurality (e.g. nine) cards comprises a defect and which is free from a defect. In an example, each card may be a PCB or the like 200. Depending on that information the unique DMC code can be generated on/in each of the plurality of cards.

In the surface treatment unit 120, the multi-profiled shape 250 in form of a dynamic data matrix code is formed by laser ablation into each individual PCB or the like 200 of the panel 300 on the top side (compare Figure 3A). Verification of the entered DMC codes 250 is done by checking (by a second identification unit; in a preferred example, the surface treatment unit and the second identification unit are equipped at a same machine part/surface) if the entered codes are in line with requirements (verification can be done automatically or manually; e.g. using a camera and comparing the image with a database), e.g. ISO29138, id3, eva3, etc.

As schematically shown in Figure 5, identification (e.g. taking an image) is done by an identification unit 160, while evaluation (e.g. verification or quality control based on the image) is done by an evaluation unit 170. In order to support the evaluation, the evaluation unit 170 is coupled to a database 180. In this manner, the evaluation unit 170 can for example compare the identified marker and/or multiple-profiled shape with reference data from the database 180. Based on the information, a unique DMC code is applied to the PCB or the like 200.

Then, in the surface treatment unit 120, a further multi-profiled shape 255 in form of a dynamic data matrix code is formed by laser ablation into an area 310 free of the PCB or the like of the panel 300 as a master code 255 on the bottom side (compare Figure 3B) (or alternatively on the same side; top side). The master DMC 255 at the bottom side can be linked with the individual DMCs 250 at the top side. Verification of the entered DMC master code 255 is done by checking if the entered code is in line with requirements (verification can be done automatically or manually), e.g. ISO29138, id3, eva3, etc. Again, the evaluation unit 170 may consult the database 180.

In this schematic illustration, the first identification/evaluation can refer to the initial identification marker 260, the second/third identification/evaluation can refer to the individual DMCs 250, and the fourth identification/evaluation can refer to the master DMC 255.

After the surface treatment, the panel 300 is sent to a cleaning unit 130 for cleaning both sides, for example using ionized gas/air and/or rinsing water. A further quality check (of the DMCs 250, 255) can be done using AVI inspection (e.g. regarding scratches).

In a labelling unit 140, the panels 300 (in particular the trays) can be labelled, e.g. with stickers, and prepared for packaging in the packaging unit 150. Additionally or alternatively, the hosting element can be labelled (with a sticker).

Preferably, in a further (separate) sub-area and/or processing area, the panel 300 may be transferred into a hosting element, for example a tray, by the handling unit. In an example, a plurality of panels 300 may be transferred into one tray. The plurality of panels 300 may be separated by a separation foil from each other. Alternatively, one panel may be hosted in a tray.

Unloading of panels 300 and/or the panels hosted in a tray may be done by the unloading unit 102.

The different sub-areas and/or processing areas and/or the loading unit 101 and/or the unloading unit 102 and/or the surface treatment unit 120 and/or the cleaning unit and/or the labelling unit 140 and/or the packaging unit 150 and/or the evaluation unit 170 and/or the database 180 may be interconnected with each other, for example by the handling unit. Additionally or alternatively, at least one of the different sub-areas and/or processing areas and/or the loading unit 101 and/or the unloading unit 102 and/or the surface treatment unit 120 and/or the cleaning unit and/or the labelling unit 140 and/or the packaging unit 150 and/or the evaluation unit 170 and/or the database 180 may be physically separated from the others, for example by a closed door, within the apparatus 100.

**Figure 6** illustrates schematically a top view on a multi-profiled shape 250 configured as a patterned code, according to an exemplary embodiment of the invention. At some positions, the exposed stacked electrically conductive layer 210 is still present after laser treatment, and at other positions, the exposed stacked electrically conductive layer 210 has been removed and exposes the other stacked electrically conductive layer 204 arranged below. In this manner, a clearly readable data matrix code can be provided efficiently and reliably.

In an embodiment, the surface treatment unit 120 may be configured to create multi-profiled shaped portions with different shapes. These shapes may e.g. a simple geometrical from such as a square a circle and/or a triangle (in the example of Figure 6, squares are used). The multi-profiled shape portions may be applied in the same vertical level or in different levels. The plurality of multi-profiled shaped portions may make up a complex geometrical structure, the multi-profiled shape 250. In this example, the multi-profiled shaped portions each has an extension defining a closed boundary profile. The multi-profiled shape 250 has an open boundary instead, i.e. no clearly defined closed boundary.

### Reference signs

- 100: Apparatus
- 101: Loading unit
- 102: Unloading unit
- 120: Surface treatment unit
- 130: Cleaning unit
- 140: Labelling unit
- 150: Packaging unit
- 160: Identification unit
- 170: Evaluation unit
- 180: Database
- 200: PCB or the like, electronic board
- 201: Layer stack
- 204: Other stacked electrically conductive layer, copper layer
- 210: Electrically conductive layer structure, Exposed stacked electrically conductive layer, silver layer
- 250: Multi-profiled shape (-d portion), individual identification
- 255: Master identification
- 260: Initial identification marker
- 270: Alignment mark
- 300: PCB or the like preform, panel
- 310: Area free of PCB or the like

## Claims

1. An apparatus (100) for treating a portion of a surface of at least one electrically conductive layer structure (210) of a layer stack (201) of a printed circuit board or the like (200),
wherein the apparatus (100) comprises a surface treatment unit (120), configured to alter along a predefined multi-profiled shape (250) a portion of the exposed surface of the at least one electrically conductive layer structure (210).

2. The apparatus (100) according to claim 1,
wherein the multi-profiled shape (250) is configured as an identification mark and/or a legend print,
in particular at least one of a barcode, a patterned code, an optically readable code, a QR-Code, a VS-code, a data matrix code, a semacode, a beetagg, a vericode, a maxicode, an aztec-code.

3. The apparatus (100) according to claim 1 or 2,
wherein the surface treatment unit (120) comprises at least one of a chemical treatment unit, a temperature treatment unit, in particular a plasma treatment unit or a laser treatment unit, more in particular a fiber laser treatment unit.

4. The apparatus (100) according to one of the preceding claims,
wherein the layer stack (201) comprises two stacked electrically conductive layers (204, 210), one of them being exposed (210), and
wherein the surface treatment unit (120) is configured to remove at least partially the exposed one (210) of the two stacked electrically conductive layers (204, 210),
in particular wherein the surface treatment unit (120) is further configured to remove a part of the other stacked electrically conductive layer (204).

5. The apparatus (100) according to one of the preceding claims,
wherein the surface treatment unit (120) is further configured to alter a multi-profiled portion having an extension defining at least one closed boundary profile within the planar extension of the exposed surface of the at least one electrically conductive layer structure (210);
and/or
wherein the surface treatment unit (120) is configured to alter a multi-profiled portion having an extension defining several multi-profiled sub-portions, in particular wherein the association thereof defines an identification mark and/or a legend print.

6. A PCB or the like (200), having a layer stack (201), comprising at least one electrically conductive layer structure (204, 210);
wherein a main surface of the at least one electrically conductive layer structure (204, 210) comprises an altered portion having a predefined multi-profiled shaped portion (250), defining an identification mark and/or a legend print.

7. The PCB or the like (200) according to claim 6,
wherein the altered portion has a surface characteristic different than that one of the remaining surface structure of the electrically conductive layer structure (204, 210),
in particular wherein the surface characteristic is at least one of the following: a roughness, a reflection, a chemical composition, a color, a conductivity.

8. The PCB or the like (200) according to claim 6 or 7,
wherein the at least one electrically conductive layer structure (204, 210) comprises two stacked electrically conductive layer structures (204, 210), and
wherein the altered portion comprises an at least partial removal of the external one (210) of the two stacked electrically conductive layers (204, 210), in particular wherein the altered portion further comprises a partial removal of the other stacked electrically conductive layer (204).

9. The PCB or the like (200) according to one of claims 6 to 8,
wherein the multi-profiled shaped portion (250) is defined by the profile of the un-removed portion of the external one (210) of the two stacked electrically conductive layers (204, 210).

10. The PCB or the like (200) according to one of claims 6 to 9,
wherein the external one (210) of the two stacked electrically conductive layers (204, 210) has a different material, in particular silver, than the other stacked electrically conductive layer (204), in particular copper.

11. The PCB or the like (200) according to one of claims 6 to 10,
wherein the external one (210) of the two stacked electrically conductive layers (204, 210) has a smaller thickness, in particular 0.5 µm or lower, than the other stacked electrically conductive layer (204).

12. The PCB or the like (200) according to one of claims 6 to 11,
wherein the altered portion comprises a multi-profiled shaped portion having an extension defining at least one closed boundary profile within the planar extension of the external surface of the at least one electrically conductive layer structure (210).

13. The PCB or the like (200) according to one of claims 6 to 12,
wherein the altered portion has an extension defining several multi-profiled sub-portions,
in particular wherein the association thereof defines an identification mark and/or a legend print.

14. The PCB or the like (200) according to one of the claims 6 to 13, further comprising:
a frame structure, wherein the multi-profiled shaped portion (250) is arranged at least partially in the frame structure,
in particular wherein the frame structure comprises a circumferential region that comprises a further altered surface encircling the multi-profile shaped portion.

15. A method of treating a portion of a surface of at least one electrically conductive layer structure (210) of a layer stack (201) of a PCB or the like (200), in particular according to one of the claims 6 to 14 and/or using an apparatus according to one of claims 1 to 5, the method comprising:
treating the PCB or the like (200) by altering along a predefined multi-profiled shape (250) a portion of the exposed surface of the at least one electrically conductive layer structure (210),
in particular wherein treating comprises using a fiber laser.
